# EUROPEAN PATENT SPECIFICATION

(11) **EP 1 357 667 B1**
(45) Date of publication and mention of the grant of the patent: **02.11.2006**
(21) Application number: 02425261.1
(22) Date of filing: 23.04.2002
(51) Int. Cl.: H03L 7/23, H03B 19/00

(54) **Frequency synthesizer and transceiver including same**
Transceiver mit Frequenzaufbereitungsschaltung
Emetteur-récepteur avec circuit de synthèse de fréquences

(43) Date of publication of application: 29.10.2003
(73) Proprietor: Siemens S.p.A., 20126 Milano (IT)
(72) Inventor: Cattaneo, Fulvio, 20050 Verano Brianza (IT); Cifelli, Antonio, 20061 Carugate (IT); Milani, Angelo, 20020 Magnago (IT); Piloni, Marco, 20090 Vimodrone (IT)
(74) Representative: Giustini, Delio

(56) References cited:
- EP-A- 0 278 140
- EP-A- 0 519 601
- EP-A- 0 526 202
- EP-A- 0 595 377
- EP-A- 0 691 747
- WO-A-98/08300
- DD-A- 289 632
- GB-A- 2 363 268
- US-A- 4 720 688
- US-A- 5 144 254
- PATENT ABSTRACTS OF JAPAN vol. 004, no. 015 (E-170), 5 February 1980 (1980-02-05) & JP 54 156409 A (TOSHIBA CORP), 10 December 1979 (1979-12-10)

## Description

### Field of the Invention

The present invention relates to frequency synthesizers and was developed by paying specific attention to the possible application to systems operating at very high frequencies such as millimeter-wave (MMW) trasmission systems.

Such systems currently operate on the basis of time division duplexing (TDD), thus permitting a single radio frequency to be used alternatively for transmission and reception. Such a frequency is generating by "beating" (i.e. mixing) a tone from a local synthesizer with the intermediate frequency (IF) signals being transmitted and received.

Since modulation is digital, usually of the PSK, FSK TFM type, in order to achieve an acceptable bit error rate (BER) the synthesizer must exhibit low phase noise. Particularly in the case of angle modulation, the synthesizer phase noise is added to the noise which is in any case present in the system during the frequency-conversion process. This may result in the synthesizer phase noise eventually comprising a significant portion of the overall phase noise at the system output.

The frequencies of the two IF signals may be identical or different, which affects system architecture and, to a good extent, performance thereof.

If a single IF frequency is used, no changes are required in the frequency of the tone generated by the synthesizer between transmission and reception. Consequently, performance of the synthesizer must be optimised in terms of phase noise only.

When applied to millimeter waves (e.g. electromagnetic waves with a frequency in excess of 20GHz) such an arrangement exhibits significant drawbacks. These drawbacks are primarily related to the difficulty, which in fact borders on impossibility, of ensuring proper insulation between the two IF signals.

Specifically, two coupling paths exist, the former being due to direct coupling between the two IF signals before conversion, while the latter is due to insufficient insulation been provided by RF switches.

In the microwave domain, this latter drawback is a particularly significant one, in that low-loss mm-wave antenna switches are not capable of providing insulation in excess of 15 dB. This fact, in addition to the same path also including the final amplifier stage and the low noise amplifier, causes this latter path to have an insulation which is typically not in excess of 65dB. As a result of this, the IF residue is at about -75dBm, which makes it of the same order of magnitude of the signal received when this latter is at a low level.

Still another drawback of this arrangement is the presence of local oscillator and image residues in the signal transmitted. The degree these residues are truly suppressed is related to the quality of the antenna filter and mixer. Operation being at high frequency, and typically at very high frequencies, makes performance of such components very critical.

Furthermore, the arrangement in question requires at least five switches. Three of these are radio frequency switches that are fairly critical to synchronise, especially in medium capacity systems having a high switching frequency.

If, conversely, the local oscillator is switched between two frequencies, problems related to mutual coupling/insulation can be solved by selecting two different values for the frequencies of the IF signals. Also, the overall system architecture is more flexible since e.g. the possibility exists of using frequency multipliers and sub-harmonic mixers operating at lower frequencies thus permitting image and local oscillator rejection performance to be improved.

In such an arrangement, the synthesizer is required to generate alternatively two frequencies, with the capability of switching between those two frequencies in a very short time interval (of the order of a few tens of microseconds) whenever switching occurs between transmission and reception.

### Background art

In current synthesizers based on a PLL (Phase-Locked Loop) layout, the two main parameters, that is switching rate and phase noise are related to the bandwidth and the order of division in the feedback loop, in addition to the VCO (Voltage Controlled Oscillator) quality. Large bandwidths permit fast switching. However, selecting an excessively broad bandwidth in the feedback loop causes the output phase noise to correspond to the phase noise of the frequency reference (usually, a quartz oscillator) increased by 6dB for each division in the feedback loop.

The frequency of the reference source is usually of the order of 10 MHz, while the output frequency at the synthesizer output is in the range of 10GHz: the number of divisions and the resulting degradation of the phase noise figure is thus unacceptable for the kind of modulation used.

In current, single-loop PLLs fast locking and a low phase noise cannot be achieved simultaneously. This is particularly true in the millimeter wave domain, where the ratio of the direct source to the reference frequency is very high. As a consequence of this, two distinct MMW synthesizers may be used, each optimised to have a low phase noise while switching the two outputs by means of a two-way switch. This switch is by way of necessity a switch required to operate in the MMW domain, that is under quite critical conditions.

Another solution practised in the prior art provides for using a single synthesizer to drive alternatively the transmitter (by applying the required modulation) and the local oscillator gate of the receiver mixer (with an unmodulated signal). In that way no need exists of shifting the synthesizer frequency. However, ensuring proper modulation (both in phase I and quadrature Q) is more complex to achieve; this also having regard to the inherent nonlinearities in the response characteristic of the voltage controlled oscillator (VCO) included in the PLL.

More specifically, the invention relates to transmission apparatus according to the preamble of Claim 1, which is known, e.g. from EP-A-0 691 747. Another document of interest for the invention is WO-A-98/08300.

### Object and summary of the Invention

The object of the present invention is thus to provide transmission apparatus overcoming the drawbacks of the prior art highlighted in the foregoing.

According to the present invention, such as object is achieved by means of transmission apparatus having the features set forth in Claim 1 that follows.

In the presently preferred embodiment of the invention, frequency synthesis occurs in two steps.

As a first step or stage, starting from the output frequency from a reference source (typically a quartz oscillator, ensuring long-term frequency stability), at least one, and preferably two tones are synthesized in the UHF band (typically a few hundred MHz) by using a PLL arrangement including a VCO optimised in order to exhibit low phase noise.

In a second step or stage, the UHF signal (s) thus generated is (are) used as a reference to lock a second VCO at the required output frequency while optimising set-up time performance.

Preferably, the UHF band VCOs comprise coaxial ceramic resonators, having a high Q value, as well as BJT transistors exhibiting a very low flicker noise figure.

A very small phase noise figure, of the order of - 130 dBc/Hz at 100 KHz from the carrier, can thus be obtained.

In order to fully exploit such a feature, the PLL including such a VCO must be narrowband, which involves relatively long locking times.

When two frequencies must be synthesised, two such VCOs are preferably implemented, each oscillating at a frequency that is a sub-multiple of those required at the synthesizer output. In that way each of the two VCOs can oscillate at a fixed frequency. Depending on need, the correct frequency can be sent by means of a switch to the subsequent phase locked oscillator. This latter oscillator is optimised by paying specific attention to set-up time.

In so far as phase noise is concerned, degradation due to the final multiplication ratio is accepted. In fact, the starting frequency is already relatively high (in the UHF range) so that the number of multiplications and the ensuing degradation in terms of phase noise performance are acceptable.

Still preferably, the two UHF oscillators are separated, both mutually and with respect to the VCO, by means of decoupling cavities comprised of an amplifier-attenuator cascade in order to avoid pulling effects.

The arrangement of the invention gives rise to excellent performance, even though involving very simple and inexpensive structure. Since only one high frequency oscillator is used, the output spectrum is very "clean", while dispensing with the mutual insulation problems inherent with the use of two separate synthesizers generating respective outputs required to be switched.

To sum up, the presently preferred embodiment of the invention relies on the basic idea of changing the output frequency of the synthesizer by switching between two frequencies (which in turn are synthesized in order to exhibit low phase noise) in the place of acting, according to conventional solution, on the number of division in the loop.

### Detailed description of a preferred embodiment of the Invention

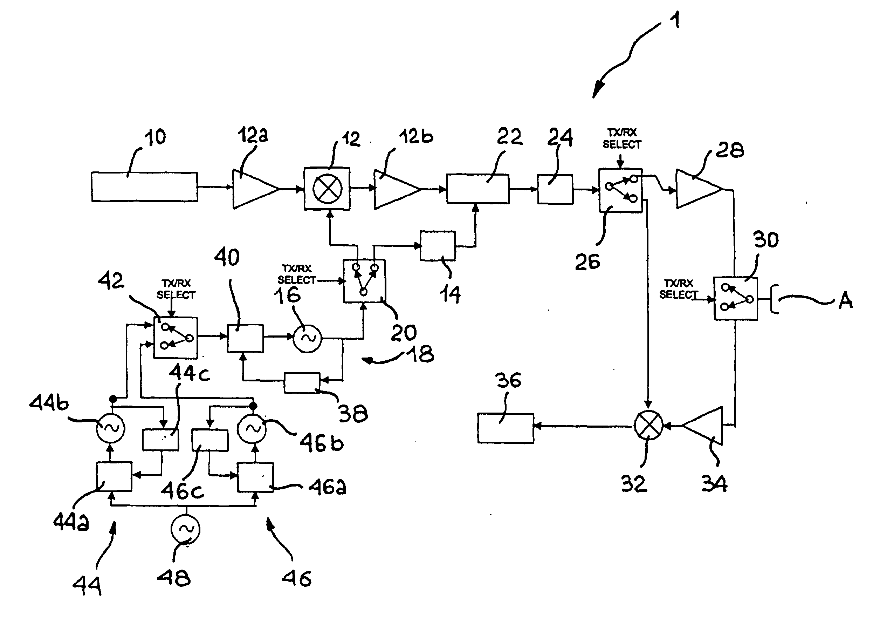

The invention will now be described, by way of example only, by referring to the enclosed figure of drawing showing the block diagram of a transceiver incorporating a synthesizer according to the invention.

In the block diagram of the enclosed drawing, a number of switches (designated 20, 26, 30, 42 and to be described in detail in the following) are shown in a first joint position (in continuous line) and a second joint position (in dotted line).

The positions shown in continuous lines refer to the configuration used during transmission (Tx on - Rx off), while the positions shown in dotted lines correspond to operation of the transceiver as a receiver (Tx off - Rx on).

Specifically, the drawing refers to an exemplary embodiment (to be regarded as such, with no intended limitation of the scope of the invention, which is defined by the annexed claims of a synthesizer for use in a transceiver (designated 1 as a whole) intended to cover the band 14.25-14.75 GHz in the transmission (Tx) mode and the band 13.705-14.205 GHz in the reception (Rx) mode.

A Tx modulated signal generated by a modulator 10 (e.g. a modulated signal centered at a frequency of 1.690 MHz) is superposed to the RF carrier in the transmission frequency range by means of a transmission mixer 12. Mixer 12 is preferably of the sub-harmonic type, having associated input and output stages 12a and 12b including amplifier and/or filter stages for rejecting local oscillator residues including the second harmonic thereof.

In the Rx mode, the frequency required for downconverting the RF received signal is obtained by means of a multiplier by two designated 14. Preferably, multiplier 14 is comprised of a FET stage biased towards pinch-off and a filter for eliminating higher harmonics.

Mixer 12 and multiplier 14 are thus fed with a "local" frequency in the 6.28 - 6.53 GHz band (in the TX mode) or the 6.8525 - 7.1025 GHz band (in the RX mode) generated by a voltage controlled oscillator (VCO) designated 16 operating in the RF range.

VCO 16 corresponds to the output stage of a frequency synthesizing chain designated as a whole by reference numeral 18. The output signal from VCO 16 is fed to mixer 12 (in the Tx mode) or multiplier 14 (in the Rx mode) by means of a switch 20. This is preferably of the SPDT (Single Pole Double Throw) type.

The outputs of these chains are coupled by means of a branch coupler 22 including a further multiplier stage 24 (this being preferably a x4 multiplier stage) to be then transferred to an output switch 26 (again preferably of the SPDT type) to be alternatively fed:
- in the Tx mode, to a high power amplifier 28 for feeding the RF transmission signal to an antenna A through an antenna switch 30, or
- in the Rx mode, to an image reject reception mixer 32 where the synthesized RF signal is mixed with the received RF signal derived from antenna A via switch 30 and a low noise amplifier 34.

The Rx signal obtained from mixing in mixer 32 is then sent towards a demodulator 36.

Amplifier 28 preferably a HPA amplifier of the balanced type which ensures the required output power (+ 10 dBm).

Voltage controlled oscillator 16 typically operates in the 7 GHz range and is based on a FET oscillator, buffered by means of discrete amplifiers. These increase the power level at about +10 dBm in order to properly drive the associated divider(s) 38 in the PLL loop.

A fast operational amplifier (not shown) controls VCO 16 by filtering the signal from phase/frequency comparator 40.

Comparator 40 operates as a frequency discriminator when the frequency generated by VCO 16 and the reference frequency are remote from each other, thus causing VCO 16 to approach the reference.

Subsequently (when the frequency difference is small) comparator 40 essentially operates as a phase comparator. This makes it possible to dispense with a "tracking" system proper and also permits, by judiciously dimensioning the loop filter, to achieve locking times of the order of few microseconds.

Comparator 40 is fed via a further switch 42, preferably again of the SPDT type, with either of the output signals generated by two UHF oscillators for the Tx mode and the Rx mode designated 44 and 46, respectively.

Oscillators 44 and 46 are essentially of the PLL type each of them including a phase comparator 44a, 46a a VCO 44b, 46b as well as a feedback loop including a divider 44c (dividing factor = M) and 46c (dividing factor = N), respectively.

Both oscillators 44 and 46 are fed by a common reference signal (e.g. in the 10 MHz range) generated by a reference oscillator such as a quartz oscillator 48.

In a preferred embodiment, oscillators 44 and 46 cover the bands 392.500 - 408.125 MHz (Tx oscillator 44) and 428.28125 - 443.90625 MHx (Rx oscillator 46) with a synthesis pitch or step of 7.8125 KHZ.

This corresponds to a pitch or step of 250 KHz at 14 GHz.

In a preferred embodiment, the RF oscillator including VCO 16 multiplies either incoming frequency from switch 42 by a factor of 16. This corresponds to a notional degradation of the phase noise figure of about 24 dB.

The loop bandwidth of both PLL oscillators 44 and 46 is very narrow (in fact these oscillators simply have to lock on a fixed frequency as generated by oscillator 48), whereby the phase noise is essentially that of the respective VCOs 44b and 46b.

These VCOs can be implemented by using coaxial dielectric resonators thus having a very low phase noise of about -125 dBc/Hz at 100 KHz offset. This phase noise is increased by multiplication at the RF level (7 GHz) and final multiplication by two (block 14). This however still gives a very low final phase noise level of about -95 dBc/Hz at 100 KHz offset at a frequency of 14 GHz.

Switching times between Tx and Rx modes are similarly very low, of the order of 5 microseconds.

Of course, the underlying principles of the invention remaining the same, the details of construction and the embodiments may widely vary with respect to what has been described and illustrated purely by way of example, without departing from the scope of the present invention, which is defined by the annexed claims. For instance, it will be promptly appreciated that the arrangement shown in the drawing by referring to two different frequencies being generated for the Tx and Rx mode may be easily extended to generating a higher number of different frequencies.

## Claims

1. Apparatus including:
- a frequency synthesizer (18), for generating a synthesized output signal having at least a first and a second output frequency, said frequency synthesizer comprising:
- a first stage (44, 46) including at least a first (44) and a second (46) input synthesizer to generate first and second respective signals having respective first and second frequencies, said respective first and second frequencies being submultiples of said first and second output frequencies, and
- a second stage (16, 38, 40) including a further synthesizer (16, 38, 40) arranged to receive selectively (42) said first and second respective signals and multiply said respective first and second frequencies to thereby obtain said synthesised output signal having at least a first and a second output frequency,
**characterised in that** said apparatus is a transceiver for transmitting a modulated signal (10) and receiving a high frequency reception signal (A, 30, 34) and includes:
- a transmission mixer (12) for mixing said modulated transmission signal (10) with said synthesizer output signal at said at least first output frequency to generate a high frequency transmission signal,
- a high frequency signal propagation path (22 to 34) for transmitting said high frequency transmission signal and receiving said high frequency reception signal,
- a reception mixer (32) for mixing said high frequency reception signal with said synthesizer output signal at said at least second output frequency to produce a reception signal suitable for demodulation (36), and
- a plurality of switching elements (20, 26, 42) adapted to be simultaneously switched between:
- a first joint operating condition wherein said first respective signal at said first respective frequency generated by said first input synthesizer (44) is fed to said second stage (16, 38, 40) and said synthesized output signal at said at least one first output frequency is fed to said transmission mixer (12) and said high frequency transmission path is configured for transmitting said high frequency transmission signal, and
- a second joint operating condition wherein said second respective signal generated by said second input synthesizer (46) at said second respective frequency is fed to said second stage (16, 38, 40), said synthesized output signal at said at least one second frequency is generated and said high frequency transmission path is configured for transmitting said synthesized output signal at said second output frequency to said reception mixer (32).

2. The transceiver of claim 1, **characterised in that** it includes a source (48) for generating a reference signal for feeding said at least a first (44) and a second (46) input synthesizer.

3. The transceiver of claim 2, **characterised in that** said source of a reference signal is a quartz oscillator (48).

4. The transceiver of either of claims 2 or 3, **characterised in that** said at least a first (44) and a second (46) input synthesizer generate said first and second respective signals by up-converting said reference signal.

5. The transceiver of any of the previous claims, **characterised in that** said at least a first (44) and a second (46) input synthesizer generate said first and second respective signals with a frequency included in the UHF band.

6. The transceiver of any of claims 2 to 4, **characterised in that** said source (48) generates a reference signal in the 10MHz range.

7. The transceiver of any of the previous claims, **characterised in that** said at least a first (44) and a second (46) input synthesizer are narrowband PLL synthesizers.

8. The transceiver of claim 7, **characterised in that** said narrowband PLL synthesizers (44, 46) have associated therewith a voltage controlled oscillator (44b, 46b) including a coaxial dielectric resonators.

9. The transceiver of claim 7, **characterised in that** it includes at least a first (44) and a second (46) narrowband PLL synthesizer, said first (44) and second (46) PLL synthesizers including respective loop dividers (44c, 46c) having different dividing ratios (M, N).

10. The transceiver of claim 1, **characterised in that** at least said at least a first (44) and a second (46) input synthesizer include oscillators (44b, 46b) having associated decoupling cavities, preferably comprised of an amplifier-attenuator cascade, in order to avoid pulling effects.

11. The transceiver of any of the previous claims, **characterised in that** said further synthesizer in said second stage includes a PLL synthesizer (16, 38, 40) adapted to be locked on said first and second respective signals generated by said at least a first (44) and a second (46) input synthesizer.

12. The transceiver of claim 11, **characterised in that** said PLL synthesizer (16, 38, 40) in said second stage includes a loop divider (38) having a dividing ratio such that that said PLL synthesizer (16, 38, 40) in said second stage up-converts to the GHz range said first and second respective signals generated by said at least a first (44) and a second (46) input synthesizer.

13. The transceiver of either of claims 11 or 12, **characterised in that** said PLL synthesizer (16, 38, 40) in said second stage includes a FET-based voltage controlled oscillator (16).

14. The transceiver of any of claims 11 to 13, **characterised in that** said PLL synthesizer (16, 38, 40) in said second stage includes a phase/frequency comparator (40).

15. The transceiver of claim 14, **characterised in that** said phase/frequency comparator is arranged to operate:
- as a frequency comparator when the frequency to be locked is remote from the frequency generated by the voltage controlled oscillator (16) included in said PLL synthesizer (16, 38, 40) in said second stage, and
- as a phase comparator when the frequency to be locked is close to the frequency generated by the voltage controlled oscillator (16) included in said PLL synthesizer (16, 38, 40) in said second stage.

16. The transceiver of claim 1, **characterised in that** said transmission mixer (12) is a sub-harmonic mixer and **in that** said high frequency propagation path includes at least one multiplier (14) for multiplying the frequency of said synthesized output signal at said at least second output frequency before feeding said synthesised output signal at said at least second frequency to said reception mixer (32).

17. The transceiver of claim 1, **characterised in that** said plurality of switch elements (20, 26, 42) are of the single pole double throw (SPDT) type.

## Patentansprüche

1. Vorrichtung, die aufweist:
- eine Frequenzaufbereitungsschaltung (18) zum Erzeugen eines aufbereiteten Ausgangssignals, das wenigstens eine erste und eine zweite Ausgangsfrequenz aufweist, wobei die besagte Frequenzaufbereitungsschaltung umfasst:
- eine erste Stufe (44, 46), die wenigstens eine erste (44) und eine zweite (46) Eingangsaufbereitungsschaltung enthält, um ein erstes und ein zweites jeweiliges Signal zu erzeugen, die eine erste bzw. zweite Frequenz aufweisen, wobei die besagte erste und zweite jeweilige Frequenz ganzzahlige Teiler der besagten ersten bzw. zweiten Ausgangsfrequenz sind, und
- eine zweite Stufe (16, 38, 40), die eine weitere Aufbereitungsschaltung (16, 38, 40) enthält, die so angeordnet ist, dass sie selektiv (42) das besagte erste und zweite jeweilige Signal empfängt und die besagte erste bzw. zweite Frequenz multipliziert, um **dadurch** das besagte aufbereitete Ausgangssignal zu erhalten, das wenigstens eine erste und eine zweite Ausgangsfrequenz aufweist,
**dadurch gekennzeichnet, dass** die besagte Vorrichtung ein Transceiver zum Senden eines modulierten Signals (10) und Empfangen eines hochfrequenten Empfangssignals (A, 30, 34) ist und enthält:
- einen Sendemischer (12) zum Mischen des besagten modulierten Sendesignals (10) mit dem besagten Ausgangssignal der Aufbereitungsschaltung bei der besagten wenigstens einen ersten Ausgangsfrequenz zum Erzeugen eines hochfrequenten Sendesignals,
- einen Hochfrequenz-Signallaufweg (22 bis 34) zum Senden des besagten hochfrequenten Sendesignals und Empfangen des besagten hochfrequenten Empfangssignals,
- einen Empfangsmischer (32) zum Mischen des besagten hochfrequenten Empfangssignals mit dem besagten Ausgangssignal der Aufbereitungsschaltung bei der besagten wenigstens einen zweiten Ausgangsfrequenz zum Erzeugen eines Empfangssignals, das für eine Demodulation (36) geeignet ist, und
- eine Vielzahl von Umschaltelementen (20, 26, 42), die so beschaffen sind, dass sie gleichzeitig umgeschaltet werden können zwischen:
- einem ersten gemeinsamen Betriebszustand, in dem das besagte erste jeweilige Signal mit der besagten ersten jeweiligen Frequenz, das von der besagten ersten Eingangsaufbereitungsschaltung (44) erzeugt wird, in die besagte zweite Stufe (16, 38, 40) eingespeist wird, und das besagte aufbereitete Ausgangssignal mit der besagten wenigstens einen ersten Ausgangsfrequenz in den besagten Sendemischer (12) eingespeist wird und der besagte Hochfrequenz-Signallaufweg für das Senden des besagten hochfrequenten Sendesignals konfiguriert ist und
- einem zweiten gemeinsamen Betriebszustand, in dem das besagte zweite jeweilige Signal, das von der besagten zweiten Eingangsaufbereitungsschaltung (46) mit der besagten zweiten jeweiligen Frequenz erzeugt wird, in die besagte zweite Stufe (16, 38, 40) eingespeist wird, das besagte aufbereitete Ausgangssignal mit der besagten wenigstens einen zweiten Frequenz erzeugt wird und der besagte Hochfrequenz-Signallaufweg für das Übertragen des besagten aufbereiteten Ausgangssignals mit der besagten zweiten Ausgangsfrequenz zu dem besagten Empfangsmischer (32) konfiguriert ist.

2. Transceiver nach Anspruch 1, **dadurch gekennzeichnet, dass** er eine Quelle (48) zum Erzeugen eines Referenzsignals zum Einspeisen in die besagte wenigstens eine erste (44) und eine zweite (46) Eingangsaufbereitungsschaltung enthält.

3. Transceiver nach Anspruch 2, **dadurch gekennzeichnet, dass** die besagte Quelle eines Referenzsignals ein Quarzoszillator (48) ist.

4. Transceiver nach einem der Ansprüche 2 oder 3, **dadurch gekennzeichnet, dass** die besagte wenigstens eine erste (44) und eine zweite (46) Eingangsaufbereitungsschaltung das besagte erste und zweite jeweilige Signal durch Aufwärtsmischung des besagten Referenzsignals erzeugen.

5. Transceiver nach einem der vorhergehenden Ansprüche, **dadurch gekennzeichnet, dass** die besagte wenigstens eine erste (44) und eine zweite (46) Eingangsaufbereitungsschaltung das besagte erste und zweite jeweilige Signal mit einer Frequenz erzeugen, die im UHF-Band enthalten ist.

6. Transceiver nach einem der Ansprüche 2 bis 4, **dadurch gekennzeichnet, dass** die besagte Quelle (48) ein Referenzsignal im Bereich von 10 MHz erzeugt.

7. Transceiver nach einem der vorhergehenden Ansprüche, **dadurch gekennzeichnet, dass** die besagte wenigstens eine erste (44) und eine zweite (46) Eingangsaufbereitungsschaltung Schmalband-PLL-Aufbereitungsschaltungen sind.

8. Transceiver nach Anspruch 7, **dadurch gekennzeichnet, dass** mit den besagten Schmalband-PLL-Aufbereitungsschaltungen (44, 46) ein spannungsgesteuerter Oszillator (444b, 46b) gekoppelt ist, der einen koaxialen dielektrischen Resonator enthält.

9. Transceiver nach Anspruch 7, **dadurch gekennzeichnet, dass** er wenigstens eine erste (44) und eine zweite (46) Schmalband-PLL-Aufbereitungsschaltung enthält, wobei die besagte erste (44) und zweite (46) PLL-Aufbereitungsschaltung jeweilige Schleifen-Teiler (44c, 46c) enthalten, die unterschiedliche Teilungsverhältnisse (M, N) aufweisen.

10. Transceiver nach Anspruch 1, **dadurch gekennzeichnet, dass** wenigstens die besagte wenigstens eine erste (44) und eine zweite (46) Eingangsaufbereitungsschaltung Oszillatoren (44b, 46b) enthalten, die zugehörige Entkopplungs-Hohlräume aufweisen, die vorzugsweise aus einer Verstärker-Dämpfungsglied-Kaskade bestehen, um Effekte des Frequenzziehens zu vermeiden.

11. Transceiver nach einem der vorhergehenden Ansprüche, **dadurch gekennzeichnet, dass** die besagte weitere Aufbereitungsschaltung in der besagten zweiten Stufe eine PLL-Aufbereitungsschaltung (16, 38, 40) enthält, die so beschaffen ist, dass sie bezüglich des besagten ersten und zweiten jeweiligen Signals verriegelt werden kann, die von der besagten wenigstens einen ersten (44) und einen zweiten (46) Eingangsaufbereitungsschaltung erzeugt werden.

12. Transceiver nach Anspruch 11, **dadurch gekennzeichnet, dass** die besagte PLL-Aufbereitungsschaltung (16, 38, 40) in der besagten zweiten Stufe einen Schleifen-Teiler (38) enthält, der ein solches Teilungsverhältnis aufweist, dass die besagte PLL-Aufbereitungsschaltung (16, 38, 40) in der besagten zweiten Stufe das besagte erste und zweite jeweilige Signal, die von der besagten wenigstens einen ersten (44) und einen zweiten (46) Eingangsaufbereitungsschaltung erzeugt werden, zum GHz-Bereich aufwärts mischt.

13. Transceiver nach einem der Ansprüche 11 oder 12, **dadurch gekennzeichnet, dass** die besagte PLL-Aufbereitungsschaltung (16, 38, 40) in der besagten zweiten Stufe einen auf einem FET beruhenden spannungsgesteuerten Oszillator (16) enthält.

14. Transceiver nach einem der Ansprüche 11 bis 13, **dadurch gekennzeichnet, dass** die besagte PLL-Aufbereitungsschaltung (16, 38, 40) in der besagten zweiten Stufe einen Phasen-/Frequenzkomparator (40) enthält.

15. Transceiver nach Anspruch 14, **dadurch gekennzeichnet, dass** der besagte Phasen-/Frequenzkomparator so beschaffen ist, dass er wirkt:
- als ein Frequenzkomparator, wenn die zu verriegelnde Frequenz von der Frequenz, die von dem spannungsgesteuerten Oszillator (16) erzeugt wird, der in der besagten PLL-Aufbereitungsschaltung (16, 38, 40) in der besagten zweiten Stufe enthalten ist, entfernt ist, und
- als ein Phasenkomparator, wenn die zu verriegelnde Frequenz nahe bei der Frequenz ist, die von dem spannungsgesteuerten Oszillator (16) erzeugt wird, der in der besagten PLL-Aufbereitungsschaltung (16, 38, 40) in der besagten zweiten Stufe enthalten ist.

16. Transceiver nach Anspruch 1, **dadurch gekennzeichnet, dass** der besagte Sendemischer (12) ein subharmonischer Mischer ist, und **dadurch**, dass der besagte Hochfrequenz-Signallaufweg wenigstens ein Multiplizierglied (14) zum Multiplizieren der Frequenz des besagten aufbereiteten Ausgangssignals mit der besagten wenigstens einen zweiten Ausgangsfrequenz vor dem Einspeisen des besagten aufbereiteten Ausgangssignals mit der besagten wenigstens einen zweiten Frequenz in den besagten Empfangsmischer (32) enthält.

17. Transceiver nach Anspruch 1, **dadurch gekennzeichnet, dass** es sich bei der besagten Vielzahl von Umschaltelementen (20, 26, 42) um Umschaltelemente vom Typ einpoliger Umschalter (Single Pole Double Throw, SPDT) handelt.

## Revendications

1. Appareil comprenant :
- un synthétiseur de fréquences (18), destiné à générer un signal de sortie synthétisé ayant au moins une première et une deuxième fréquence de sortie, ledit synthétiseur de fréquences comprenant :
- un premier niveau (44, 46) comprenant au moins un premier (44) et un deuxième (46) synthétiseur d'entrée pour générer des premier et deuxième signaux respectifs ayant des première et deuxième fréquences respectives, lesdites première et deuxième fréquences respectives étant des sous-multiples desdits première et deuxième fréquences de sortie respectives, et
- un deuxième niveau (16, 38, 40) comprenant un autre synthétiseur (16, 38, 40) agencé pour recevoir sélectivement (42) lesdits premier et deuxième signaux respectifs et multiplier lesdites première et deuxième fréquences pour obtenir ainsi ledit signal de sortie synthétisé ayant au moins une première et une deuxième fréquence de sortie,
**caractérisé en ce que** ledit appareil est un émetteur-récepteur pour transmettre un signal modulé (10) et recevoir un signal de réception haute fréquence (A, 30, 34) et comprend :
- un mélangeur de transmission (12) pour mélanger ledit signal de transmission modulé (10) audit signal de sortie du synthétiseur à ladite au moins première fréquence de sortie pour générer un signal de transmission haute fréquence,
- un trajet de propagation du signal haute fréquence (22 à 34) pour transmettre ledit signal de transmission haute fréquence et recevoir ledit signal de réception haute fréquence,
- un mélangeur de réception (32) pour mélanger ledit signal de réception haute fréquence audit signal de sortie du synthétiseur à ladite au moins deuxième fréquence de sortie pour produire un signal de réception convenable pour la démodulation (36), et
- une pluralité d'éléments de commutation (20, 26, 42) adaptés pour être commutés simultanément entre :
- une première condition de fonctionnement conjointe dans laquelle ledit premier signal respectif à ladite première fréquence respective générée par ledit premier synthétiseur d'entrée (44) est amené audit deuxième niveau (16, 38, 40) et ledit signal de sortie synthétisé à ladite au moins une première fréquence de sortie est amené audit mélangeur de transmission (12) et ledit trajet de transmission haute fréquence est configuré pour transmettre ledit signal de transmission haute fréquence, et
- une deuxième condition de fonctionnement conjointe dans laquelle ledit deuxième signal respectif généré par ledit deuxième synthétiseur d'entrée (46) à ladite deuxième fréquence respective est amené audit deuxième niveau (16, 38, 40), ledit signal de sortie synthétisé à ladite au moins une deuxième fréquence est généré et ledit trajet de transmission haute fréquence est configuré pour transmettre ledit signal de sortie synthétisé à ladite deuxième fréquence de sortie audit mélangeur de réception (32).

2. Émetteur-récepteur selon la revendication 1, **caractérisé en ce qu'**il comprend une source (48) pour générer un signal de référence destiné à alimenter au moins un premier (44) et un deuxième (46) synthétiseur d'entrée.

3. Émetteur-récepteur selon la revendication 2, **caractérisé en ce que** ladite source d'un signal de référence est un oscillateur à quartz (48).

4. Émetteur-récepteur selon l'une ou l'autre des revendications 2 ou 3, **caractérisé en ce que** ledit au moins un premier (44) et un deuxième (46) synthétiseur d'entrée génèrent lesdits premier et deuxième signaux respectifs en procédant à une conversion élévatrice dudit signal de référence.

5. Émetteur-récepteur selon l'une des revendications précédentes, **caractérisé en ce que** ledit au moins un premier (44) et un deuxième (46) synthétiseur d'entrée génèrent lesdits premier et deuxième signaux respectifs avec une fréquence comprise dans la bande UHF.

6. Émetteur-récepteur selon l'une quelconque des revendications 2 à 4, **caractérisé en ce que** ladite source (48) génère un signal de référence dans la plage de 10MHz.

7. Émetteur-récepteur selon l'une quelconque des revendications précédentes, **caractérisé en ce que** ledit au moins un premier (44) et un deuxième (46) synthétiseur d'entrée sont des synthétiseurs à verrouillage de phase à bande étroite.

8. Émetteur-récepteur selon la revendication 7, **caractérisé en ce que** les synthétiseurs à verrouillage de phase à bande étroite (44, 46) ont, associé à eux, un oscillateur commandé en tension (44b, 46b) comprenant des résonateurs diélectriques coaxiaux.

9. Émetteur-récepteur selon la revendication 7, **caractérisé en ce qu'**il comprend au moins un premier (44) et un deuxième (46) synthétiseur à verrouillage de phase à bande étroite, lesdits premier (44) et deuxième (46) synthétiseurs à verrouillage de phase comprenant des diviseurs de boucle (44c, 46c) ayant différents rapports de division (M, N).

10. Émetteur-récepteur selon la revendication 1, **caractérisé en ce qu'**au moins ledit au moins un premier (44) et un deuxième (46) synthétiseurs d'entrée comprennent des oscillateurs (44b, 46b) ayant des cavités de découplage associées, constituées de préférence d'une cascade amplificateur-atténuateur afin d'éviter des effets d'entraînement.

11. Émetteur-récepteur selon l'une quelconque des revendications précédentes, **caractérisé en ce que** ledit autre synthétiseur dudit deuxième niveau comprend un synthétiseur à verrouillage de phase (16, 38, 40) adapté pour être verrouillé sur lesdits premier et deuxième signaux respectifs générés par ledit au moins un premier (44) et un deuxième (46) synthétiseur d'entrée.

12. Émetteur-récepteur selon la revendication 11, **caractérisé en ce que** ledit synthétiseur à verrouillage de phase (16, 38, 40) dudit deuxième niveau comprend un diviseur de boucle (38) ayant un rapport de division tel que ce dit synthétiseur à verrouillage de phase (16, 38, 40) dudit deuxième niveau procède à une conversion élévatrice à la plage GHz desdits premier et deuxième signaux respectifs générés par ledit au moins un premier (44) et un deuxième (46) synthétiseur d'entrée.

13. Émetteur-récepteur selon l'une ou l'autre des revendications 11 ou 12, **caractérisé en ce que** ledit synthétiseur à verrouillage de phase (16, 38, 40) dudit deuxième niveau comprend un oscillateur commandé en tension basé sur un transistor à effet de champ (16).

14. Émetteur-récepteur selon l'une quelconque des revendications 11 à 13, **caractérisé en ce que** ledit synthétiseur à verrouillage de phase (16, 38, 40) dudit deuxième niveau comprend un comparateur phase / fréquence (40).

15. Émetteur-récepteur selon la revendication 14, **caractérisé en ce que** ledit comparateur phase / fréquence est agencé pour fonctionner :
- comme un comparateur de fréquences lorsque la fréquence à verrouiller est éloignée de la fréquence générée par l'oscillateur commandé en tension (16) compris dans ledit synthétiseur à verrouillage de phase (16, 38, 40) dudit deuxième niveau, et
- comme un comparateur de phases lorsque la fréquence à verrouiller est proche de la fréquence générée par l'oscillateur commandé en tension (16) compris dans ledit synthétiseur à verrouillage de phase (16, 38, 40) dudit deuxième niveau.

16. Émetteur-récepteur selon la revendication 1, **caractérisé en ce que** ledit mélangeur de transmission (12) est un mélangeur sous-harmonique et **en ce que** ledit trajet de propagation haute fréquence comprend au moins un multiplicateur (14) pour multiplier la fréquence dudit signal de sortie synthétisé à ladite au moins deuxième fréquence de sortie avant d'alimenter ledit signal de sortie synthétisé à ladite au moins deuxième fréquence audit mélangeur de réception (32).

17. Émetteur-récepteur selon la revendication 1, **caractérisé en ce que** ladite pluralité d'éléments de commutation (20, 26, 42) est de type unipolaire bidirectionnel (SPDT).
